# EUROPÄISCHE PATENTSCHRIFT

(11) **EP 2 758 993 B1**
(45) Veröffentlichungstag und Bekanntmachung des Hinweises auf die Patenterteilung: **16.12.2015**
(21) Anmeldenummer: 12768756.4
(22) Anmeldetag: 14.09.2012
(51) Int. Cl.: H01L 27/142, H01L 31/0224, H01L 31/042, H01L 31/0352

(54) **DÜNNSCHICHTSOLARMODUL MIT SERIENVERSCHALTUNG UND VERFAHREN ZUR SERIENVERSCHALTUNG VON DÜNNSCHICHTSOLARZELLEN**
THIN FILM SOLAR MODULE HAVING SERIES CONNECTION AND METHOD FOR THE SERIES CONNECTION OF THIN FILM SOLAR CELLS
MODULE SOLAIRE À COUCHES MINCES À CÂBLAGE EN SÉRIE ET PROCÉDÉ DE CÂBLAGE EN SÉRIE DE CELLULES SOLAIRES À COUCHES MINCES

(30) Priorität: 19.09.2011 EP 11181769
(43) Veröffentlichungstag der Anmeldung: 30.07.2014
(73) Patentinhaber: Saint-Gobain Glass France, 92400 Courbevoie (FR)
(72) Erfinder: KARG, Franz, 80689 München (DE)
(74) Vertreter: Gebauer, Dieter Edmund
(86) Internationale Anmeldenummer: PCT/EP2012/068171
(87) Internationale Veröffentlichungsnummer: WO 2013/041467

(56) Entgegenhaltungen:
- WO-A2-2010/012259
- WO-A2-2011/000361
- US-A1- 2008 156 372
- US-A1- 2009 065 060
- US-A1- 2011 197 952

## Beschreibung

Die Erfindung betrifft ein Dünnschichtsolarmodul mit Serienverschaltung und ein Verfahren zur Serienverschaltung von Dünnschichtsolarzellen zu einem Dünnschichtsolarmodul.

Photovoltaische Schichtsysteme zur direkten Umwandlung von Sonnenstrahlung in elektrische Energie sind hinreichend bekannt. Die Materialien und die Anordnung der Schichten sind so abgestimmt, dass einfallende Strahlung von einer oder mehreren halbleitenden Schichten mit möglichst hoher Strahlungsausbeute direkt in elektrischen Strom umgewandelt wird. Photovoltaische und flächig ausgedehnte Schichtsysteme werden als Solarzellen bezeichnet.

Solarzellen enthalten in allen Fällen Halbleitermaterial. Solarzellen, die zur Bereitstellung einer ausreichenden mechanischen Festigkeit Trägersubstrate benötigen, werden als Dünnschichtsolarzellen bezeichnet. Aufgrund der physikalischen Eigenschaften und der technologischen Handhabbarkeit sind Dünnschichtsysteme mit amorphen, mikromorphen oder polykristallinen Silizium, Cadmium-Tellurid (CdTe), Gallium-Arsenid (GaAs), Kupfer-Indium-(Gallium)-Selenid-Sulfid (Cu(In,Ga)(S,Se)₂), Kupfer-Zink-Zinn-Sulfo-Selenid (CZTS aus der Gruppe der Kesterite) sowie organischen Halbleitern besonders für Solarzellen geeignet. Der pentenäre Halbleiter Cu(In,Ga)(S,Se)₂ gehört zur Gruppe der Chalkopyrit-Halbleiter, die häufig als CIS (Kupferindiumdiselenid oder -sulfid) oder CIGS (Kupferindiumgalliumdiselenid, Kupferindiumgalliumdisulfid oder Kupferindiumgalliumdisulfoselenid) bezeichnet werden. S kann in der Abkürzung CIGS für Selen, Schwefel oder eine Mischung beider Chalkogene stehen.

Bekannte Trägersubstrate für Dünnschichtsolarzellen enthalten anorganisches Glas, Polymere, Metalle oder Metalllegierungen und können in Abhängigkeit von Schichtdicke und Materialeigenschaften als starre Platten oder biegsame Folien ausgestaltet sein. Aufgrund der weitreichend verfügbaren Trägersubstrate und einer einfachen monolithischen Serienverschaltung können großflächige Anordnungen von Dünnschichtsolarzellen kostengünstig hergestellt werden.

Eine elektrische Schaltung von mehreren Solarzellen wird als Photovoltaik- oder Solarmodul bezeichnet. Die Schaltung von Solarzellen wird in bekannten witterungsstabilen Aufbauten dauerhaft vor Umwelteinflüssen geschützt. Üblicherweise sind eisenarme Natron-Kalk-Gläser und haftvermittelnde Polymerfolien mit den Solarzellen zu einem bewitterungsstabilen Photovoltaikmodul verbunden. Die Photovoltaikmödule können über Anschlussdosen in eine Schaltung von mehreren Photovoltaikmodulen eingebunden sein. Die Schaltung von Photovoltaikmodulen ist über bekannte Leistungselektronik mit dem öffentlichen Versorgungsnetz oder einer autarken elektrischen Energieversorgung verbunden.

Bei der Serienverschaltung von Dünnschichtsolarmodulen wird in der Regel eine integrierte Serienverschaltung eingesetzt. Bei der integrierten Serienverschaltung wird die aktive Zellenfläche in Längsstreifen unterteilt, die jeweils eine einzelne Dünnschichtsolarzelle darstellen. Die einzelnen Dünnschichtsolarzellen werden an ihren Längskanten mit den jeweils benachbarten Zellen serienverschaltet. Dabei werden Rückelektrodenschicht, photoaktive Halbleiterschicht und Frontelektrodenschicht durch Strukturierungslinien PR, PA, PF unterteilt und die Rückelektrodenschicht eines ersten Bereichs über eine zweite Strukturierungslinie PA mit der Frontelektrodenschicht eines angrenzenden Bereichs verbunden. Eine gattungsgemäße Verschaltung ist z.B. in US 2008/156372 A1 offenbart.

In der Praxis hat sich gezeigt, dass der Wirkungsgrad einer einzelnen Dünnschichtsolarzelle mit zunehmender Solarzellenbreite sinkt. Um die Verluste des Solarmoduls zu begrenzen, kann die Breite einer einzelnen Solarzelle je nach verwendeter Zellenstruktur etwa 1 cm bei CIS-Solarmodulen beziehungsweise 1 cm bis 1,5 cm bei amorphen Silizium-Solarmodulen nicht übersteigen. Dünnschichtsolarmodule mit einzelnen Solarzellen von größerer Breite wären wegen ihrer geringen Spannungen und höheren Strömen für bestimmte Anwendungen vorteilhaft, beispielsweise zum Laden von Batterien.

Die Aufgabe der vorliegenden Erfindung liegt darin, ein verbessertes Dünnschichtsolarmodul mit einem höheren Wirkungsgrad bei verbreiterten einzelnen Dünnschichtsolarzellen - gleichbedeutend mit einer pro Modulfläche reduzierten Anzahl serienverschalteter Einzelsolarzellen - bereitzustellen.

Die Aufgabe der vorliegenden Erfindung wird erfindungsgemäß durch ein Dünnschichtsolarmodul mit Serienverschaltung gemäß Anspruch 1 gelöst. Bevorzugte Ausführungen gehen aus den Unteransprüchen hervor.

Des Weiteren umfasst die Erfindung ein Verfahren zur Serienverschaltung von Dünnschichtsolarzellen zu einem Dünnschichtsolarmodul.

Eine Verwendung des erfindungsgemäßen Verfahrens geht aus weiteren Ansprüchen hervor.

Eine einzelne Dünnschichtsolarzelle besteht im Wesentlichen aus drei Schichten: einer Rückelektrodenschicht auf der lichtabgewandten Seite, einer Frontelektrodenschicht und einer photoaktiven Halbleiterschicht dazwischen. Der durch Lichteinfall generierte Stromfluss wird innerhalb einer Solarzelle senkrecht zu den drei Strukturierungslinien PR, PA, PF in der Frontelektrodenschicht gesammelt, zur zweiten Strukturierungslinie PA geleitet und von dort nach unten zur Rückelektrodenschicht der benachbarten Zelle weitergeleitet.

Eine grundlegende Charakteristik dieses Designs ist die in Richtung der Serienverschaltung stark ansteigende Stromdichte innerhalb der Frontelektrodenschicht, beziehungsweise die abfallende Stromdichte in der Rückelektrodenschicht. Im Gegensatz zur Rückelektrodenschicht, die in der Regel aus hochleitenden Metallen besteht, weist die Frontelektrodenschicht eine um mindestens den Faktor 2, meist jedoch mindestens den Faktor 10-100 geringere Leitfähigkeit auf. Dies ist bedingt durch die Forderung nach einer hohen optischen Transparenz der Frontelektrodenschicht, die nur bei dünnen, nicht zu stark dotierten Frontelektrodenschichten gegeben ist. Bedingt durch die niedrige Leitfähigkeit der Frontelektrodenschicht kommt es zu erheblichen ohmschen Verlusten, die nichtlinear in Querrichtung zur Solarzelle ansteigen. Bei einer starken Reduktion der Solarzellenbreite werden zwar die ohmschen Verluste reduziert, allerdings steigen damit die Verluste an aktiver Fläche, bedingt durch die ansteigende Zahl von Strukturierungslinien PR, PA, PF und den damit einhergehenden photovoltaisch inaktiven Flächenanteilen. Bei einer gegebenen Solarmodulbreite kann damit die Zahl der einzelnen Solarzellen und somit die Gesamtspannung des Solarmoduls nicht in weiten Bereichen variiert werden. Die optimale Breite der Zelle wₒₚₜ bei gegebenen opto-elektronischen Eigenschaften von photoaktiver Halbleiterschicht und Frontelektrodenschicht liegt damit in ziemlich engen Grenzen fest.

Die erfindungsgemäße Lösung des Problems liegt in einer Nutzung der ausreichend vorhandenen Leitfähigkeit der metallischen Rückelektrodenschicht zur Unterstützung des Stromflusses, der normalerweise von der Frontelektrodenschicht übernommen werden müsste. Dazu wird die Form einer einzelnen Solarzelle nicht als exaktes Rechteck ausgebildet, sondern weist an einer Längskante Ausbuchtungen auf, in denen der Stromfluss von der schwach leitenden Frontelektrodenschicht durch die Rückelektrodenschicht über die zweite, in besonderer Ausprägung hergestellte Strukturierungslinie PA übernommen wird. Die zur Stromsammlung erforderlichen mittleren Wegstrecken innerhalb der Frontelektrodenschicht können damit reduziert werden. Es ergeben sich somit geringere Serienwiderstandsverluste und neue Freiheitsgrade bei der Gestaltung der elektrischen Charakteristik von Dünnschichtsolarmodulen. Bei gegebenen Substrat-Formaten kann die Zahl der einzelnen Solarzellen und damit das Spannungs-/Stromverhältnis des Solarmoduls nahezu frei gewählt werden. Insbesondere für Anwendungen zur Batterieladung durch Photovoltaikmodule sind dies entscheidende Voraussetzungen. Aber auch bei anderen Anwendungen ist es vorteilhaft, Module mit geringeren Spannungen und höheren Strömen einzusetzen, beispielsweise um längere Ketten serienverschalteter Solarzellen innerhalb einer großen Photovoltaikanlage konfigurieren zu können.

Ein erfindungsgemäßes Dünnschichtsolarmodul mit Serienverschaltung auf einem Substrat umfasst daher zumindest:
- eine Rückelektrodenschicht, die durch Strukturierungslinien PR unterteilt ist,
- eine photoaktive Halbleiterschicht, die auf der Rückelektrodenschicht angeordnet ist und durch Strukturierungslinien PA unterteilt ist und
- eine Frontelektrodenschicht, die auf der, der Rückelektrodenschicht gegenüberliegenden Seite der photoaktiven Halbleiterschicht angeordnet ist und die mittels Strukturierungslinien PF unterteilt ist.

Über die Strukturierungslinie PA erfolgt eine elektrische Verbindung von Front- und Rückelektrode benachbarter Einzelzellen. Des Weiteren sind die Strukturierungslinien PR mit Ausbuchtungen und Kanten und die zweiten Strukturierungslinien PA mit Ausbuchtungen und Kanten so zueinander ausgebildet, dass die mittlere Wegstrecke des in der photoaktiven Halbleiterschicht erzeugten Stromes durch die Frontelektrodenschicht verringert ist.

Kante im Sinne der vorliegenden Erfindung ist ein Abschnitt einer Strukturierungslinie PA, PR oder PF der nicht eine Ausbuchtung umfasst.

Das erfindungsgemäße Dünnschichtsolarmodul kann in der sogenannten Substratkonfiguration oder der sogenannten Superstratekonfiguation aufgebaut werden. In beiden Konfigurationen erfolgt der Aufbau aus mehreren dünnen, halbleitenden und metallischen Schichten auf einem isolierenden plattenförmigen Material.

Eine vorteilhafte Ausgestaltung eines erfindungsgemäßen Dünnschichtsolarmoduls mit Serienverschaltung in Substratkonfiguration umfasst mindestens:
- eine Rückelektrodenschicht, die auf einem Substrat angeordnet ist und die durch Strukturierungslinien PR unterteilt ist,
- eine photoaktive Halbleiterschicht, die auf der Rückelektrodenschicht angeordnet ist und die durch Strukturierungslinien PA unterteilt ist und
- eine Frontelektrodenschicht, die auf der photoaktiven Halbleiterschicht angeordnet ist, wobei mindestens die Frontelektrodenschicht durch Strukturierungslinien PF in Bereiche unterteilt ist und die Frontelektrodenschicht eines ersten Bereichs in Serienverschaltung mit der Rückelektrodenschicht eines zweiten Bereichs verbunden ist,
wobei die Strukturierungslinien PR mit Ausbuchtungen und Kanten und die Strukturierungslinien PA mit Ausbuchtungen und Kanten so zueinander ausgebildet sind, dass die mittlere Wegstrecke des in der photoaktiven Halbleiterschicht erzeugten Stromes durch die Frontelektrodenschicht verringert ist.

In einer bevorzugten Ausgestaltung des erfindungsgemäßen Dünnschichtsolarmoduls sind die Frontelektrodenschicht und die photoaktive Halbleiterschicht durch Strukturierungslinien PF in Bereiche unterteilt.

Das Substrat besteht hier beispielsweise aus Glas mit einer relativ geringen Lichtdurchlässigkeit, wobei gleichermaßen andere elektrisch isolierende Materialien mit gewünschter Festigkeit und inertem Verhalten gegenüber den durchgeführten Prozessschritten eingesetzt werden können.

Die hochleitfähige Rückelektrodenschicht enthält beispielsweise ein Metall wie Molybdän (Mo), Aluminium (A1), Kupfer (Cu) oder Titan (Ti) und kann beispielsweise durch Aufdampfen oder durch magnetfeldunterstützte Kathodenzerstäubung auf das Substrat aufgebracht werden. Die Rückelektrodenschicht ist durch erste Strukturierungslinien PR unterteilt.

Auf der Rückelektrodenschicht ist eine photoaktive Halbleiterschicht angeordnet, die auch die Strukturierungslinien PR auffüllt. Als photoaktive Halbleiterschicht eignet sich jeder für die Herstellung von Dünnschichtsolarzellen geeignete Schichtaufbau. Ein solcher Schichtaufbau enthält vorzugsweise amorphes, mikromorphes oder polykristallines Silizium unterschiedlicher Dotierung, Cadmium-Tellurid (CdTe), Gallium-Arsenid (GaAs), Kupfer-Zink-Zinn-Sulfo-Selenid (CZTS), organischen Halbleitern oder Kupfer-Indium-(Gallium)-Selenid-Sulfid (Cu (In, Ga) (S, Se)₂). Die photoaktive Halbleiterschicht ist zumindest durch die Strukturierungslinien PA unterteilt, kann aber auch zusätzlich durch die Strukturierungslinien PF unterteilt sein.

Auf der photoaktiven Halbleiterschicht ist zumindest eine Frontelektrodenschicht angeordnet, die für Strahlung im Bereich der spektralen Empfindlichkeit der Solarzelle weitgehend transparent ist, so dass das einstrahlende Sonnenlicht nur gering geschwächt wird. Die Frontelektrodenschicht füllt auch die Strukturierungslinien PA in der photoaktiven Halbleiterschicht auf, wodurch die Frontelektrodenschicht eines ersten Bereichs mit der Rückelektrodenschicht eines zweiten Bereichs in Serienverschaltung verbunden wird.

Die Frontelektrodenschicht enthält vorzugsweise eine transparente, leitfähige Metalloxidschicht, insbesondere Zinkoxid (ZnO), aluminiumdotiertes Zinkoxid (ZnO:Al), bordotiertes Zinkoxid (ZnO:B), indiumdotiertes Zinkoxid (ZnO:In), galliumdotiertes Zinkoxid (ZnO:Ga), fluordotiertes Zinnoxid (SnO₂:F), antimondotiertes Zinnoxid (SnO₂:Sb) oder Indiumzinnoxid (ITO). Die Frontenelektrodenschicht kann beispielsweise durch Aufdampfen, chemische Gasphaseabscheidung (CVD) oder durch magnetfeldunterstützte Kathodenzerstäubung auf die photoaktive Halbleiterschicht aufgebracht werden. Vor der Abscheidung der Frontelektrode kann zur Verbesserung der optoelektronischen Eigenschaften auch zusätzlich eine dünne Pufferschicht (z.B. aus II-VI- oder III-V Halbleitern) aufgebracht werden.

Im Falle der Substratkonfiguration sind die Frontelektrodenschicht und gegebenenfalls auch die photoaktive Halbleiterschicht durch Strukturierungslinien PF unterteilt, wodurch die einzelnen Dünnschichtsolarzellen des Dünnschichtsolarmoduls miteinander serienverschaltet werden.

Eine vorteilhafte Ausgestaltung eines erfindungsgemäßen Dünnschichtsolarmoduls mit Serienverschaltung in Superstratekonfiguration umfasst mindestens:
- eine Frontelektrodenschicht, die auf einem transparenten Substrat angeordnet ist und die durch Strukturierungslinien PF unterteilt ist,
- eine photoaktive Halbleiterschicht, die auf der Frontelektrodenschicht angeordnet ist und die durch Strukturierungslinien PA unterteilt ist und
- eine Rückelektrodenschicht, die auf der photoaktiven Halbleiterschicht angeordnet ist, wobei zumindest die Rückelektrodenschicht durch Strukturierungslinien PR in Bereiche unterteilt ist und die Rückelektrodenschicht eines ersten Bereichs in Serienverschaltung mit der Frontelektrodenschicht eines zweiten Bereichs verbunden ist,
   wobei die Strukturierungslinien PR mit Ausbuchtungen und Kanten und die Strukturierungslinien PA mit Ausbuchtungen und Kanten so zueinander ausgebildet sind, dass die mittlere Wegstrecke des in der photoaktiven Halbleiterschicht erzeugten Stromes durch die Frontelektrodenschicht verringert ist.

Die Ausgestaltung in der Superstratekonfiguration erfolgt durch einen Schichtaufbau auf der lichtabgewandten Oberfläche eines transparenten Substrats. Das transparente Substrat besteht beispielsweise aus extraweißem Glas mit geringem Eisengehalt, wobei gleichermaßen andere elektrisch isolierende und optisch transparente Materialien mit gewünschter Festigkeit und inertem Verhalten gegenüber den durchgeführten Prozessschritten eingesetzt werden können.

Bei dieser Ausgestaltung des erfindungsgemäßen Dünnschichtsolarmoduls ist die Frontelektrodenschicht durch Strukturierungslinien PF unterteilt, die photoaktive Halbleiterschicht durch zweite Strukturierungslinien PA unterteilt und zumindest die Rückelektrodenschicht, gegebenenfalls auch die angrenzende Absorberschicht durch dritte Strukturierungslinien PR unterteilt. Die Serienverschaltung der einzelnen Dünnschichtsolarzellen erfolgt in diesem Falle durch die Verbindung der Rückelektrodenschicht eines ersten Bereichs mit der Frontelektrodenschicht eines zweiten Bereichs.

Bei dem erfindungsgemäßen Dünnschichtsolarmodul sind die Strukturierungslinien PR mit Ausbuchtungen und Kanten und die Strukturierungslinien PA mit Ausbuchtungen und Kanten so zueinander ausgebildet, dass die mittlere Wegstrecke des in der photoaktiven Halbleiterschicht erzeugten Stromes durch die Frontelektrodenschicht verringert ist.

Der in der photoaktiven Halbleiterschicht erzeugte Strom wird durch die Frontelektrode aufgenommen und über die zweite Strukturierungslinie PA zur Rückelektrodenschicht der in Serienverschaltung folgenden Dünnschichtsolarzelle weitergeleitet. Die Ausbuchtungen der zweiten Strukturierungslinie PA führen dazu, dass der Strom nicht mehr in geraden Bahnen parallel zur Längs- oder Serienverschaltungsrichtung der Dünnschichtsolarzelle durch die Frontelektrodenschicht fließt, sondern dem Pfad des niedrigsten elektrischen Widerstands folgt. Durch die Ausbuchtungen der zweiten Strukturierungslinie PA wird der mittlere Abstand verschiedener Bereiche der Frontelektrodenschicht zur zweiten Strukturierungslinie PA verringert. Dadurch wird die mittlere Wegstrecke des in der photoaktiven Halbleiterschicht erzeugten Stromes durch die Frontelektrodenschicht verringert und der mittlere elektrische Widerstand durch die Frontelektrodenschicht reduziert. Der elektrische Strom wird über die Strukturierungslinie PA in die besser elektrisch leitende Rückelektrodenschicht geführt. Dies führt zu einem niedrigeren Gesamtwiderstand der Dünnschichtsolarzelle.

In einer vorteilhaften Ausgestaltung des erfindungsgemäßen Dünnschichtsolarmoduls sind auch die Strukturierungslinien PF mit analogen Ausbuchtungen und Kanten ausgebildet. Durch diese Maßnahme kann die photovoltaisch aktive Fläche jeder einzelnen Dünnschichtsolarzelle vergrößert werden, da die photovoltaisch inaktive Fläche zwischen zweiter Strukturierungslinie PA und der benachbarten dritten Strukturierungslinie PR verkleinert wird.

In einer weiteren vorteilhaften Ausgestaltung des erfindungsgemäßen Dünnschichtsolarmoduls sind die Ausbuchtungen der Strukturierungslinie PR, der Strukturierungslinien PA und PR oder der Strukturierungslinie PR, PA und PF spitz zulaufend ausgebildet.

In einer weiteren vorteilhaften Ausgestaltung des erfindungsgemäßen Dünnschichtsolarmoduls sind die Ausbuchtungen von mindestens der Strukturierungslinien PR, gegebenenfalls auch die Strukturierungslinien PA und/oder PF dreiecksförmig ausgebildet.

In einer weiteren vorteilhaften Ausgestaltung des erfindungsgemäßen Dünnschichtsolarmoduls sind die Ausbuchtungen der Strukturierungslinien PA linienförmig oder rechteckig ausgebildet. Diese Ausgestaltung der Strukturierungslinien PA ist technisch besonders einfach durchführbar.

In einer weiteren vorteilhaften Ausgestaltung des erfindungsgemäßen Dünnschichtsolarmoduls sind die Ausbuchtungen benachbarter Strukturierungslinien PR, PA und PF zumindest annähernd parallel nebeneinander ausgebildet. Dadurch wird die photovoltaisch inaktive Fläche zwischen den Strukturierungslinien PF, PA und PR verkleinert und die photovoltaisch aktive Fläche jeder einzelnen Dünnschichtsolarzelle vergrößert. Hierbei sind die Ausbuchtungen der Strukturierungslinien PR, PA und gegebenenfalls PF in dieselbe Richtung (z.B. senkrecht zur Erstreckung der Strukturierungslinien) gerichtet, d.h. die Strukturierungslinien sind jeweils in dieselbe Richtung (z.B. senkrecht zu deren Erstreckung) ausgebaucht. Somit sind,die Strukturierungslinien PR, PA und gegebenenfalls PF mit gleichgerichteten Ausbuchtungen versehen.

Die mittlere Wegstrecke des in der photoaktiven Halbleiterschicht erzeugten Stromes durch die Frontelektrodenschicht, im Folgenden auch Photostrom genannt, ist bevorzugt kleiner oder gleich der optimalen Zellenbreite wₒₚₜ.

Wie eingangs bereits geschildert, hat sich in der Praxis gezeigt, dass der Wirkungsgrad einer einzelnen Dünnschichtsolarzelle mit zunehmender Solarzellenbreite sinkt. Dies ist unter anderem die Folge des mit der Zellenbreite zunehmenden ohmschen Widerstands, resultierend in erster Linie aus der begrenzten Leitfähigkeit der transparenten Frontelektrode. Umgekehrt steigt mit abnehmender Zellenbreite der relative Anteil der opto-elektronisch inaktiven Fläche, die für die Strukturierungslinien benötigt wird. Die aus diesen beiden gegenläufigen Effekten resultierende optimale Zellenbreite wₒₚₜ hängt bei herkömmlicher Serienverschaltung im Wesentlichen von der Spannung und der Photostromdichte einer jeweiligen Solarzelle ab. Wie Versuche gezeigt haben, beträgt die optimale Zellenbreite wₒₚₜ bei einem CIS- oder CIGS-Dünnschichtsolarmodul mit einer Leerlaufspannung von ca. 0,5 V und vergleichsweise hohen Photostromdichten etwa von 5 mm bis 10 mm und bevorzugt von 4,5 mm bis 6,5 mm. Bei Solarzellen mit hohen Leerlaufspannungen und vergleichsweise niedrigen Photostromdichten, wie beispielsweise amorphen Siliziumsolarzellen mit einer Leerlaufspannung von ca. 0,9 V, beträgt die optimale Zellenbreite wₒₚₜ beispielsweise von 7 mm bis 15 mm und bevorzugt von 7,5 mm bis 10,5 mm.

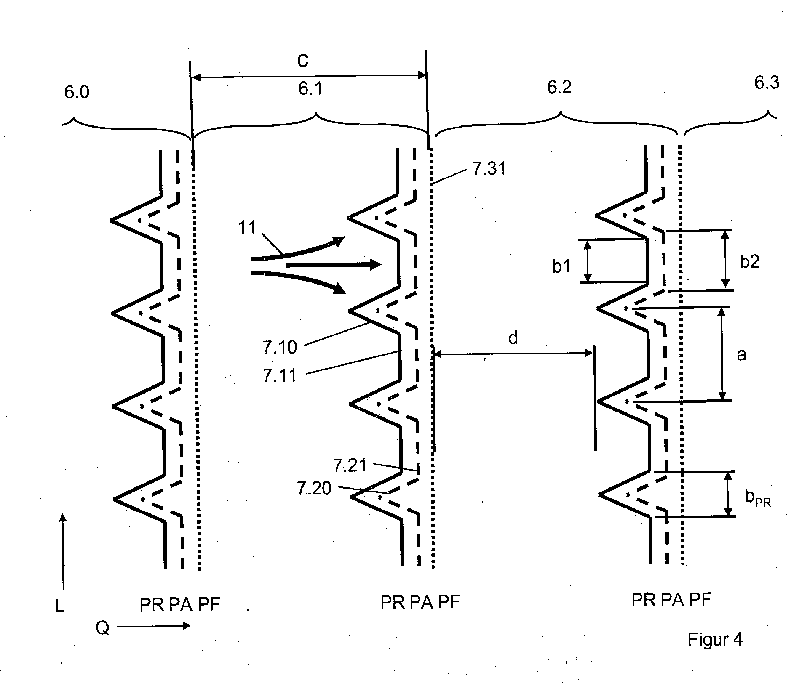

In einer weiteren vorteilhaften Ausgestaltung des erfindungsgemäßen Dünnschichtsolarmoduls sind die Ausbuchtungen der Strukturierungslinie PR mit einem minimalen Abstand d zur Strukturierungslinie PF der benachbarten Zelle von kleiner oder gleich der optimalen Zellenbreite wₒₚₜ ausgebildet. Die für den Abstand d relevante Strukturierungslinie PF befindet sich auf der der nächstliegenden Strukturierungslinie PA abgewandten Seite (siehe zur Verdeutlichung beispielsweise Figur 4). Die relevante Strukturierungslinie PF grenzt die Frontelektrodenschicht zu der in Serienverschaltung vorhergehenden Dünnschichtsolarzelle ab.

In einer vorteilhaften Ausgestaltung des erfindungsgemäßen Dünnschichtsolarmoduls sind die Ausbuchtungen mit einem Abstand a entlang der Strukturierungslinien ausgebildet, wobei der Abstand a kleiner oder gleich dem doppelten Abstand von wₒₚₜ entspricht. Dies hat den besonderen Vorteil, dass der zwischen den beiden Ausbuchtungen generierte Photostrom einen Weg der kleiner oder gleich der optimalen Zellenbreite wₒₚₜ ist, zurücklegen muss, um über die Strukturierungslinie PA zur Rückelektrode zu gelangen.

In einer weiteren vorteilhaften Ausgestaltung des erfindungsgemäßen Dünnschichtsolarmoduls hat die Rückelektrodenschicht einen um mindestens den Faktor 10, bevorzugt den Faktor 100 geringeren elektrischen Flächenwiderstand als die Frontelektrodenschicht. Dadurch ist es möglich die Basisbreite b_{PR} der Ausbuchtungen der Strukturierungslinie PR der Rückelektrode zu reduzieren. Eine Reduktion der Basisbreite b_{PR} führt zu einer Verringerung der photoelektrisch inaktiven Fläche und führt damit zu einer Erhöhung des Wirkungsgrads.

Ein weiterer Aspekt der Erfindung umfasst ein Verfahren zur Herstellung und Serienverschaltung eines Dünnschichtsolarmoduls in einer sogenannten Substratkonfiguration, wobei:
a) eine Rückelektrodenschicht auf einem Substrat abgeschieden wird und die Rückelektrodenschicht durch erste Strukturierungslinien PR unterteilt wird,
b) eine photoaktive Halbleiterschicht auf der Rückelektrodenschicht abgeschieden wird und die photoaktive Halbleiterschicht durch zweite Strukturierungslinien PA unterteilt wird,
c) eine Frontelektrodenschicht auf der photoaktiven Halbleiterschicht abgeschieden wird, die Frontelektrodenschicht und die photoaktive Halbleiterschicht durch dritte Strukturierungslinien PF in Bereiche unterteilt werden und die Frontelektrodenschicht eines ersten Bereichs in Serienverschaltung mit der Rückelektrodenschicht eines zweiten Bereich verbunden wird,
wobei die erste Strukturierungslinie PR mit Ausbuchtungen und Kanten und die zweite Strukturierungslinie PA mit Ausbuchtungen und Kanten so zueinander ausgebildet werden, dass die mittlere Wegstrecke des in der photoaktiven Halbleiterschicht erzeugten Stromes durch die Frontelektrodenschicht verringert wird.

Ein weiterer Aspekt der Erfindung umfasst ein erfindungsgemäßes Verfahren zur Herstellung und Serienverschaltung eines Dünnschichtsolarmoduls in einer sogenannten Superstratekonfiguration, wobei
a) eine Frontelektrodenschicht auf einem transparenten Substrat abgeschieden wird und die Frontelektrodenschicht durch erste Strukturierungslinien PF unterteilt wird,
b) eine photoaktive Halbleiterschicht auf der Frontelektrodenschicht abgeschieden wird und die photoaktive Halbleiterschicht durch zweite Strukturierungslinien PA unterteilt wird,
c) eine Rückelektrodenschicht auf der photoaktiven Halbleiterschicht abgeschieden wird, die Rückelektrodenschicht und die photoaktive Halbleiterschicht durch dritte Strukturierungslinien PR in Bereiche unterteilt werden und die Rückelektrodenschicht eines ersten Bereichs in Serienverschaltung mit der Frontelektrodenschicht eines zweiten Bereichs verbunden wird,
wobei die Strukturierungslinien PR mit Ausbuchtungen und Kanten und die Strukturierungslinien PA mit Ausbuchtungen und Kanten so zueinander ausgebildet werden, dass die mittlere Wegstrecke des in der photoaktiven Halbleiterschicht erzeugten Stromes durch die Frontelektrodenschicht verringert wird.

Ein weiterer Aspekt der Erfindung umfasst die Verwendung des erfindungsgemäßen Verfahrens zur Herstellung und Serienverschaltung eines Dünnschichtsolarmoduls, insbesondere eines Dünnschichtsolarmoduls aus amorphen, mikromorphen oder polykristallinen Silizium, Cadmium-Tellurid (CdTe), Gallium-Arsenid (GaAs), Kesterit-basierten Halbleiter wie Kupfer-Zink-Zinn-Sulfo-Selenid (CZTS), Chalkopyritbasierten Halbleiter wie Kupfer-Indium-(Gallium)-Selenid-Sulfid (Cu(In,Ga)(S,Se)₂) oder organischen Halbleiter.

### Kurze Beschreibung der Zeichnungen

Die Erfindung wird nachfolgend anhand von Figuren und eines Beispiels näher erläutert. Die Figuren sind nicht vollständig maßstabsgetreu. Die Erfindung wird durch die Figuren in keiner Weise eingeschränkt. Es zeigen:
- Figur 1: eine schematische Querschnittsdarstellung eines Ausführungsbeispiels des erfindungsgemäßen Dünnschichtsolarmoduls mit zwei seriell verbundenen Dünnschichtsolarzellen,
- Figur 2: eine Querschnittsdarstellung entlang der Schnittlinie A-A' aus Figur 1,
- Figur 3: eine schematische Darstellung des Stromflusses durch zwei seriell verbundene Dünnschichtsolarzellen,
- Figur 4: eine schematische Darstellung der Abfolge der Strukturierungslinien PR, PA und PF eines erfindungsgemäßen Dünnschichtsolarmoduls,
- Figur 5: eine schematische Darstellung einer alternativen Ausgestaltung der Strukturierungslinien PR, PA und PF eines erfindungsgemäßen Dünnschichtsolarmoduls,
- Figur 6: eine schematische Darstellung einer alternativen Ausgestaltung der Strukturierungslinien PR, PA und PF eines erfindungsgemäßen Dünnschichtsolarmoduls,
- Figur 7: eine schematische Darstellung einer alternativen Ausgestaltung der Strukturierungslinien PR, PA und PF eines erfindungsgemäßen Dünnschichtsolarmoduls,
- Figur 8: eine schematische Darstellung einer alternativen Ausgestaltung der Strukturierungslinien PR, PA und PF eines erfindungsgemäßen Dünnschichtsolarmoduls,
- Figur 9: eine schematische Querschnittsdarstellung eines alternativen Ausführungsbeispiels (Superstrateaufbau) eines erfindungsgemäßen Dünnschichtsolarmoduls,
- Figur 10: eine schematische Darstellung der Abfolge der Strukturierungslinien PR, PA und PF eines erfindungsgemäßen Dünnschichtsolarmoduls (Superstrateaufbau),
- Figur 11: ein detailliertes Flussdiagramm des erfindungsgemäßen Verfahrens, und
- Figur 12: ein detailliertes Flussdiagramm einer alternativen Ausführungsform des erfindungsgemäßen Verfahrens.

### Ausführliche Beschreibung der Zeichnungen

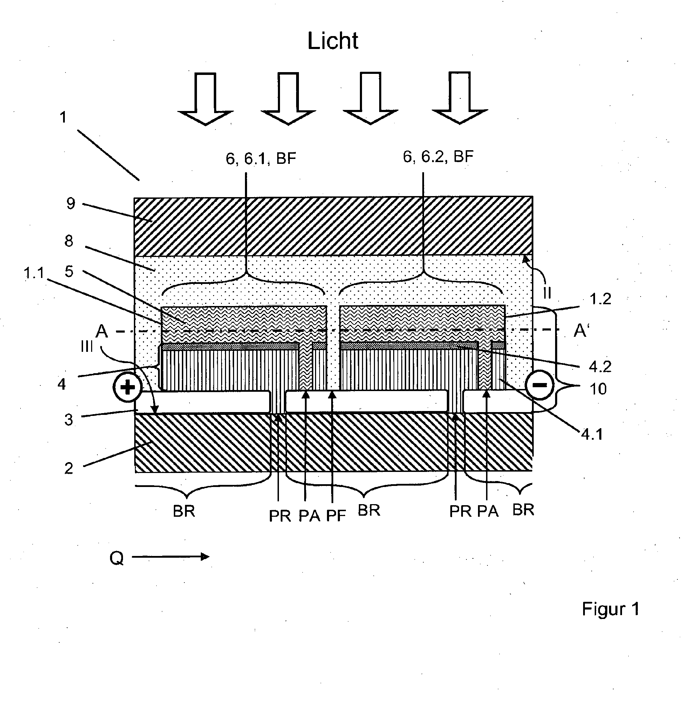

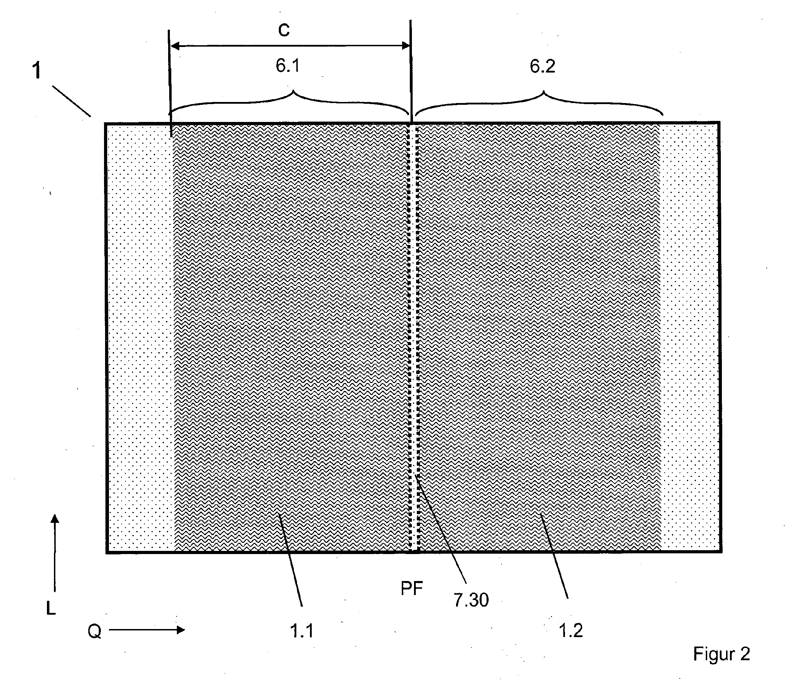

In Figur 1 ist ein insgesamt mit der Bezugszahl 1 bezeichnetes Dünnschichtsolarmodul veranschaulicht. Das Dünnschichtsolarmodul 1 umfasst eine Mehrzahl in integrierter Form seriell verschalteter Solarzellen 1.1, 1.2, von denen in der Figur 1 zwei dargestellt sind. Figur 2 zeigt eine Querschnittsdarstellung entlang der Schnittlinie A-A' aus Figur 1. Die Richtung L gibt die Längsrichtung oder die Richtung parallel zu den Strukturierungslinien an, die Richtung Q gibt die Querrichtung senkrecht zu den Strukturierungslinien des Dünnschichtsolarmoduls 1 an.

Das Dünnschichtsolarmodul 1 hat einen der so genannten Substratkonfiguration entsprechenden Aufbau. Das heißt es verfügt über ein elektrisch isolierendes Substrat 2 mit einem darauf aufgebrachten Schichtenaufbau 10 aus dünnen Schichten. Der Schichtenaufbau 10 ist auf der lichteintrittsseitigen Oberfläche III des Substrats 2 angeordnet. Das Substrat 2 besteht hier beispielsweise aus Glas, das auch eine relativ geringe Lichtdurchlässigkeit aufweisen kann (aber nicht muss).

Der Schichtenaufbau 10 umfasst eine auf der Oberfläche III des Substrats 2 angeordnete Rückelektrodenschicht 3. Die Rückelektrodenschicht 3 ist durch Strukturierungslinien PR unterteilt. Die Rückelektrodenschicht 3 enthält beispielsweise ein lichtundurchlässiges Metall wie Molybdän (Mo) und kann beispielsweise durch Aufdampfen oder durch magnetfeldunterstützte Kathodenzerstäubung auf das Substrat 2 aufgebracht werden. Die Rückelektrodenschicht 3 hat eine Schichtdicke von 100 nm bis 600 nm, welche beispielsweise 500 nm beträgt. Die Rückelektrodenschicht 3 hat einen elektrischen Flächenwiderstand von 1 Ohm/Quadrat bis 0,01 Ohm/Quadrat und beispielsweise von 0,1 Ohm/Quadrat.

Auf der Rückelektrodenschicht 3 ist eine photoaktive Halbleiterschicht 4 abgeschieden. Die photoaktive Halbleiterschicht 4 ist durch Strukturierungslinien PA unterteilt. Die photoaktive Halbleiterschicht 4 enthält beispielsweise einen dotierten Halbleiter, dessen Bandabstand vorzugsweise in der Lage ist, einen möglichst großen Anteil des Sonnenlichts zu absorbieren. Die photoaktive Halbleiterschicht 4 umfasst beispielsweise eine Absorberschicht 4.1 und eine Pufferschicht 4.2. Die Absorberschicht 4.1 enthält beispielsweise einen p-leitenden Chalkopyrithalbleiter, beispielsweise eine Verbindung der Gruppe Cu(In,Ga)(S,Se)₂. Die Absorberschicht 4.1 hat beispielsweise eine Schichtdicke von 0,5 µm bis 5 µm und beispielsweise von etwa 2 µm.

Auf die Absorberschicht 4.1 ist eine Pufferschicht 4.2 abgeschieden, die hier beispielsweise aus einer Einzellage Cadmiumsulfid (CdS) und einer Einzellage aus intrinsischem Zinkoxid (i-ZnO) besteht, was in Figur 1 nicht näher dargestellt ist.

Auf die Pufferschicht 4.2 ist eine Frontelektrodenschicht 5 beispielsweise durch Sputtern aufgebracht. Die Frontelektrodenschicht 5 füllt auch die Strukturierungslinien PA auf, wodurch eine elektrische Leitungsverbindung zwischen der Frontelektrodenschicht 5 eines ersten Bereichs 6.1 und der Rückelektrodenschicht 3 eines zweiten Bereichs 6.2 gebildet wird. Die Frontelektrodenschicht 5 ist für Strahlung im sichtbaren Spektralbereich transparent ("Fensterelektrode"), so dass das einstrahlende Sonnenlicht nur gering geschwächt wird. Die transparente Frontelektrodenschicht 5 basiert beispielsweise auf einem dotierten Metalloxid, beispielsweise n-leitendes Aluminium (A1)-dotiertes Zinkoxid (ZnO:Al). Eine solche Frontelektrodenschicht 5 wird allgemein als TCO-Schicht (TCO = Transparent Conductive Oxide) bezeichnet. Durch die Frontelektrodenschicht 5 wird gemeinsam mit der Pufferschicht 4.2 und der Absorberschicht 4.1 ein Heteroübergang (d.h. eine Abfolge von Schichten vom entgegengesetzten Leitungstyp) gebildet. Dabei kann die Pufferschicht 4.2 eine elektronische Anpassung zwischen dem halbleitenden Material der Absorberschicht 4.1 und dem Material der Frontelektrodenschicht 5 bewirken. Die Frontelektrodenschicht 5 hat eine Schichtdicke von 100 nm bis 2000 nm, welche beispielsweise 1000 nm beträgt. Die Frontelektrodenschicht 5 hat einen Flächenwiderstand von 5 Ohm/Quadrat bis 20 Ohm/Quadrat und beispielsweise von 10 Ohm/Quadrat. Die Frontelektrodenschicht 5 und die photoaktive Halbleiterschicht 4 sind durch Strukturierungslinien PF in einzelne Dünnschichtsolarzellen 1.1, 1.2 unterteilt.

Zum Schutz vor Umwelteinflüssen ist auf der Frontelektrodenschicht 5 eine beispielsweise aus einem Polymer bestehende Klebeschicht 8 aufgebracht, die zur Verkapselung des Schichtenaufbaus 10 dient. Die lichteintrittsseitige Oberfläche III des Substrats 2 und die lichtaustrittsseitige Oberfläche II eines transparenten Substrats 9 sind durch die Klebeschicht 8 fest miteinander verbunden. Die Klebeschicht 8 ist hier beispielsweise eine thermoplastische Klebeschicht, die durch Erwärmen plastisch verformbar wird und beim Abkühlen das Substrat 2 und das transparente Substrat 9 fest miteinander verbindet. Für die Verkapselung geeignete Klebeschichten 8 sind beispielsweise Polyvinylbutyral (PVB)- oder Ethylenvinyacetat (EVA)-Folien. Die Polyvinylbutyral (PVB)- oder Ethylenvinyacetat (EVA)-Folien haben beispielsweise eine Dicke von 1 mm.

Das transparente Substrat 9 besteht beispielsweise aus extraweißem Glas mit geringem Eisengehalt, wobei gleichermaßen andere elektrisch isolierende Materialien mit gewünschter Festigkeit und inertem Verhalten gegenüber den durchgeführten Prozessschritten eingesetzt werden können.

Obgleich in Figur 1 und Figur 2 nicht näher dargestellt, ist ein umlaufender Randspalt zwischen dem Substrat 2 und dem transparenten Substrat 9 mit einem als Barriere für Wasser dienenden Dichtmaterial abgedichtet. Die Abdichtung verbessert die Langzeitstabilität des Dünnschichtsolarmoduls 1 durch eine Hemmung des Eintritts von Wasser und reduziert die Korrosion der verschiedenen Schichten des Schichtenaufbaus 10. Ein geeignetes Dichtmaterial ist beispielsweise Polyisobutylen (PIB).

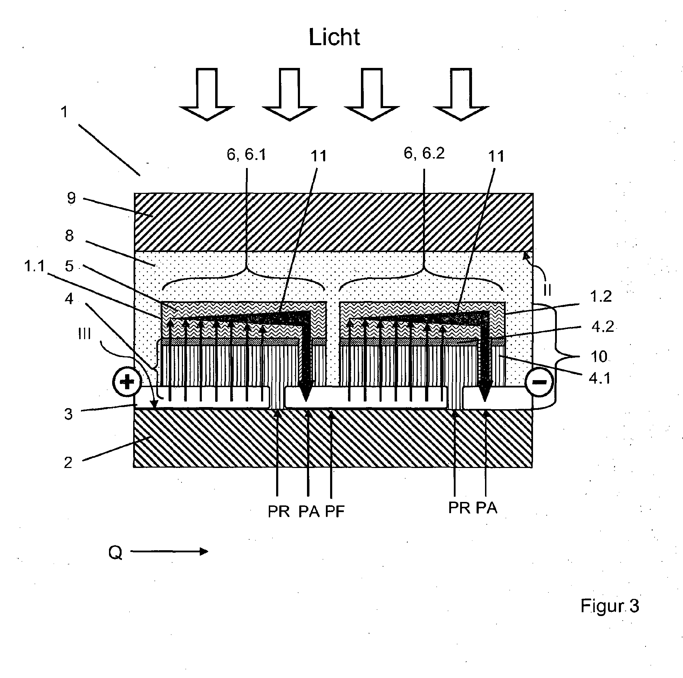

Figur 3 zeigt eine schematische Darstellung des Stromflusses durch zwei seriell verbundene Dünnschichtsolarzellen 1.1, 1.2. Der in der photoaktiven Halbleiterschicht 4 erzeugte elektrische Strom wird in der Frontelektrodenschicht 5 eines ersten Bereichs 6.1 gesammelt und entlang des Strompfads 11 zur Strukturierungslinie PA geleitet. Die Leitung des elektrischen Stromes zur Rückelektrodenschicht 2 eines zweiten Bereichs 6.2 erfolgt über die Strukturierungslinie PA.

Im hier dargestellten Beispiel sind sowohl der resultierende positive (+) als auch der resultierende negative Spannungsanschluss (-) des Dünnschichtsolarmoduls 1 über die Rückelektrodenschicht 3 geführt und dort elektrisch kontaktiert. Ein erfindungsgemäßes Dünnschichtsolarmodul 1 enthält beispielsweise ca. 100 seriell verschaltete Dünnschichtsolarzellen 1.1, 1.2 und weist eine Leerlaufspannung von ca. 50 Volt auf. Die Breite c einer einzelnen Dünnschichtsolarzelle beträgt von 3 mm bis 20 mm und beispielsweise 10 mm.

Figur 4 zeigt eine schematische Darstellung der Abfolge der Strukturierungslinien PR, PA und PF von vier in Serie verschalteten Bereichen 6.0, 6.1, 6.2, und 6.3. Der Abstand benachbarter Strukturierungslinien PR sowie der Abstand benachbarter Strukturierungslinien PA entspricht der Breite c der einzelnen Dünnschichtsolarzellen 1.1, 1.2.

Die Strukturierungslinien PR weisen Ausbuchtungen 7.10 und die Strukturierungslinien PA Ausbuchtungen 7.20 auf. Die benachbarten Strukturierungslinien PR und PA sind annähernd parallel nebeneinander ausgebildet bzw. haben einen parallelen Verlauf. Die Ausbuchtungen 7.10 der Strukturierungslinien PR und die Ausbuchtungen 7.20 der Strukturierungslinien PA haben jeweils einen Abstand a von beispielsweise 12 mm. Der Abstand a entspricht dabei etwa der doppelten optimalen Zellenbreite wₒₚₜ von 6 mm. Zwischen den Ausbuchtungen 7.10 verlaufen die Strukturierungslinien PR in Längsrichtung L entlang der Kanten 7.11. Die Basisbreite b_{PR} der Ausbuchtungen 7.10 beträgt beispielsweise 2 mm. Die Länge b1 der Kanten 7.11 beträgt beispielsweise 10 mm. Die Länge b2 der Kanten 7.20 der Strukturierungslinien PA beträgt beispielsweise 11 mm. Der minimale Abstand d einer Ausbuchtung 7.10 einer Strukturierungslinie PR zur in Richtung der Serienverschaltung L davorliegenden, benachbarten Strukturierungslinie PF entspricht der optimalen Zellenbreite wₒₚₜ und beträgt beispielsweise 6 mm. Die Strukturierungslinien PF sind in diesem Ausführungsbeispiel ohne Ausbuchtungen ausgeführt und weisen nur eine durchgehende Kante 7.31 auf. Die Ausbuchtungen 7.10, 7.20 sind jeweils senkrecht (entgegen Richtung Q) zur Erstreckung (Richtung L) der Strukturierungslinien PA, PR ausgebuchtet.

Die Strompfade des in der photoaktiven Halbleiterschicht 4 erzeugten Stromes durch die Frontelektrodenschicht 5 sind durch Pfeile mit der Bezugszahl 11 gekennzeichnet. Die Strompfade 11 verlaufen entlang des Weges mit dem niedrigsten Widerstand, wodurch sich die mittlere Wegstrecke des Stromes durch die Frontelektrodenschicht 5 im Vergleich zu serienverschalteten Solarzellen nach dem Stand der Technik verringert. Eine Verlagerung des Stromtransports von der hochohmigeren Frontelektrodenschicht 5 zur niederohmigeren Rückelektrodenschicht 3 resultiert in einem niedrigeren Gesamtwiderstand der Dünnschichtsolarzelle.

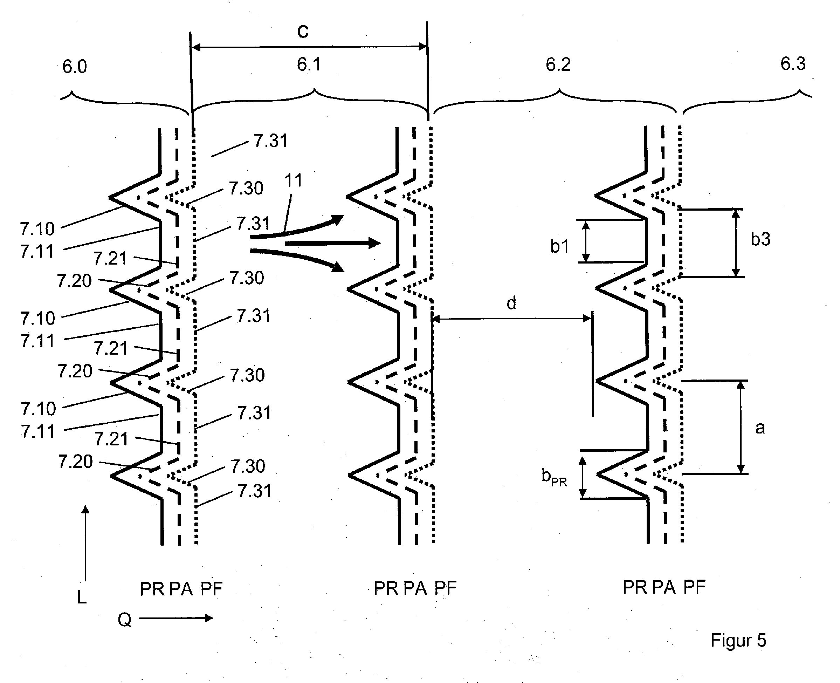

Figur 5 zeigt eine schematische Darstellung einer alternativen Ausgestaltung der Strukturierungslinien PR, PA und PF von vier in Serie verschalteten Bereichen 6.0, 6.1, 6.2, und 6.3. Die Strukturierungslinien PF sind mit Ausbuchtungen 7.30 und Kanten 7.31 ausgebildet. Die benachbarten Strukturierungslinien PR, PA und PF sind annähernd parallel nebeneinander ausgebildet bzw. haben einen parallelen Verlauf. Die Ausbuchtungen 7.10, 7.20 und 7.30 sind jeweils senkrecht (entgegen Richtung Q) zur Erstreckung (Richtung L) der Strukturierungslinien PA, PR bzw. PF ausgebuchtet.

Die Länge b3 der Kanten 7.31 beträgt beispielsweise 11 mm. Hierdurch wird die photovoltaisch inaktive Fläche zwischen Strukturierungslinie PA und der benachbarten Strukturierungslinie PF minimiert und die photovoltaisch aktive Fläche jeder einzelnen Dünnschichtsolarzelle 1.1, 1.2, 1.3 vergrößert.

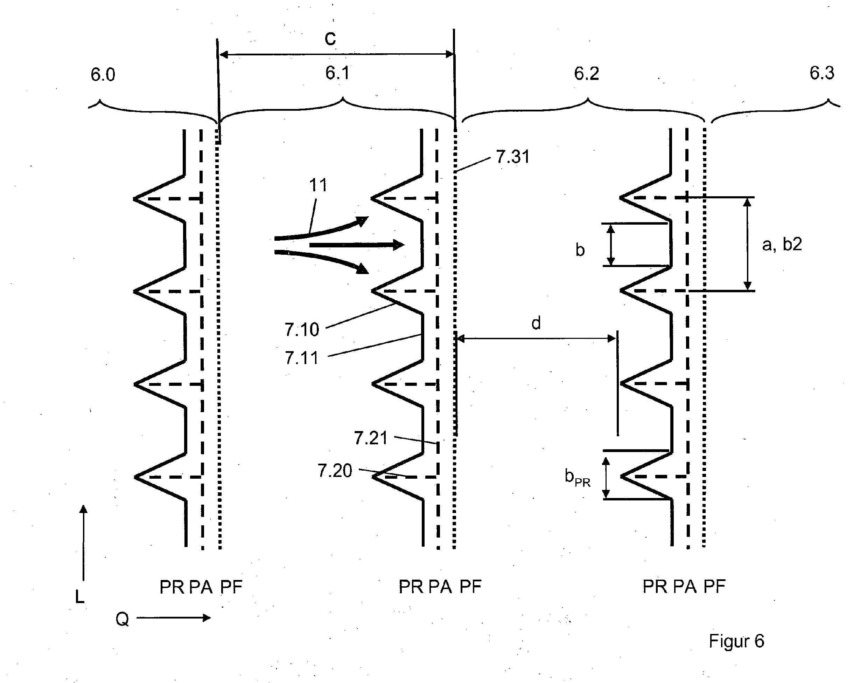

Figur 6 zeigt eine schematische Darstellung einer weiteren alternativen Ausgestaltung der Strukturierungslinien PR, PA und PF eines erfindungsgemäßen Dünnschichtsolarmoduls 1. Die Ausbuchtungen 7.20 der Strukturierungslinien PA sind in diesem Ausführungsbeispiel linienförmig ausgestaltet. Die Länge b2 der Kanten 7.21 entspricht in diesem Beispiel dem Abstand a der Ausbuchtungen 7.20.

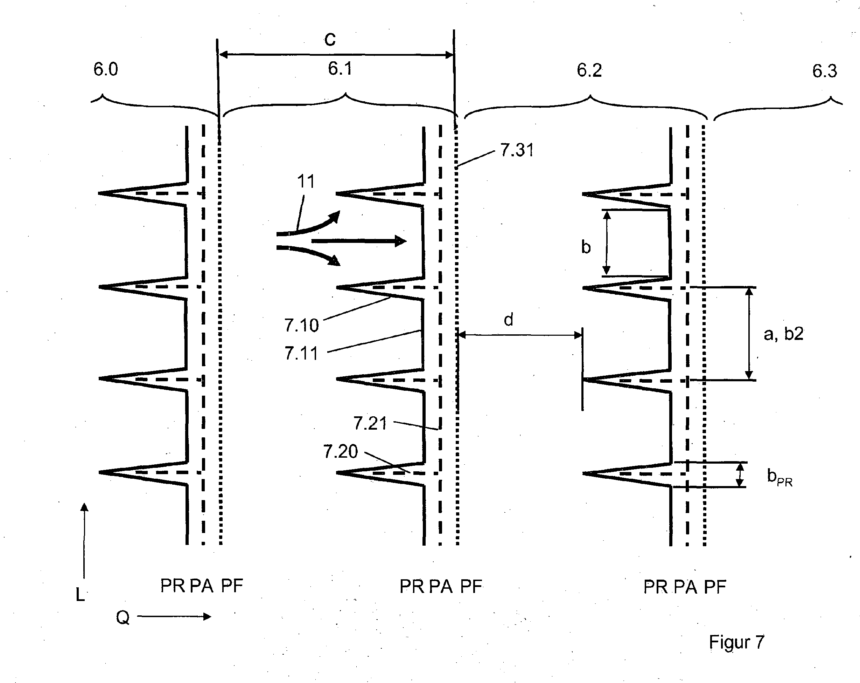

Figur 7 zeigt eine Variante des Ausführungsbeispiels aus Figur 6. Der Abstand d zwischen der Strukturierungslinie PR und der Strukturierungslinie PF zweier benachbarter Bereiche ist im Vergleich zu Figur 6 verringert, wobei gleichzeitig die Länge b1 der Kante 7.11 vergrößert ist und die Basisbreite b_{PR} verkleinert ist.

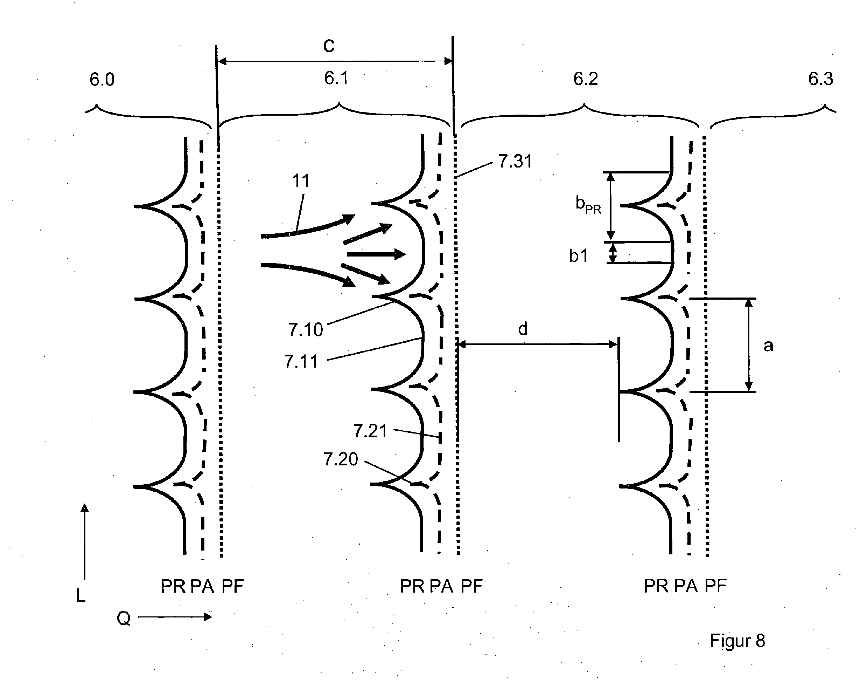

Figur 8 zeigt eine schematische Darstellung einer weiteren alternativen Ausgestaltung der Strukturierungslinien PR, PA und PF eines erfindungsgemäßen Dünnschichtsolarmoduls 1. Die Ausbuchtungen 7.10 der Strukturierungslinien PR und die Ausbuchtungen 7.20 der Strukturierungslinien PA sind abgerundet und spitz zulaufend ausgebildet. Die Länge b1 der Kante 7.11 der Strukturierungslinie PR und die Länge b2 der Kante 7.21 der Strukturierungslinie PA kann im Grenzfall auch 0 sein, so dass die Strukturierungslinien PR und PA nur aus abgerundeten Ausbuchtungen 7.10, 7.20 bestehen. Die abgerundete Form der Ausbuchtungen 7.20 ermöglicht eins besonders effektive Verkürzung der mittleren Wegstrecke der Strompfade 11 in der Frontelektrodenschicht 5.

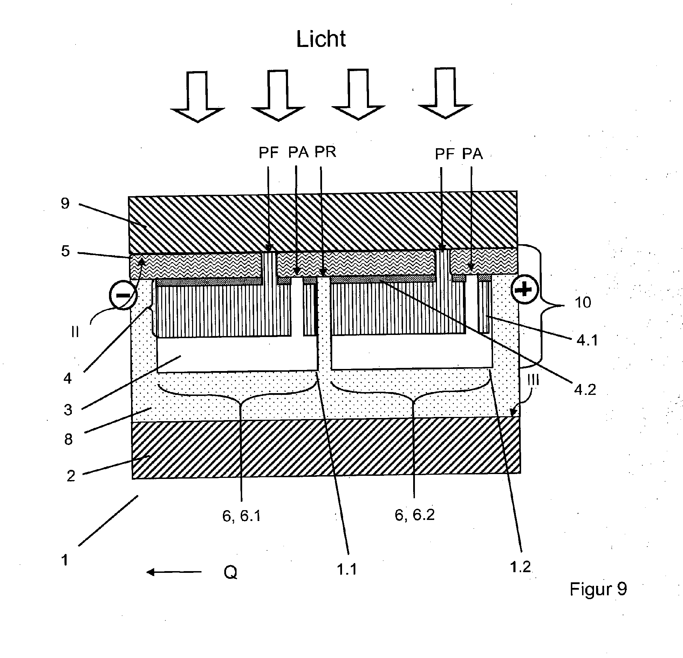

Figur 9 zeigt eine schematische Querschnittsdarstellung eines alternativen Ausführungsbeispiels des erfindungsgemäßen Dünnschichtsolarmoduls 1 mit zwei seriell verbundenen Dünnschichtsolarzellen 1.1, 1.2. Das Dünnschichtsolarmodul 1 hat einen der so genannten Superstratekonfiguration entsprechenden Aufbau, das heißt es verfügt über ein transparentes Substrat 9 mit einem darauf aufgebrachten Schichtenaufbau 10 aus dünnen Schichten. Der Schichtenaufbau 10 umfasst eine auf der lichtaustrittsseitigen Oberfläche II des Substrats 9 angeordnete Frontelektrodenschicht 5, die durch Strukturierungslinien PF unterteilt ist. Auf der Frontelektrodenschicht 5 ist eine photoaktive Halbleiterschicht 4 abgeschieden. Die photoaktive Halbleiterschicht 4 ist durch Strukturierungslinien PA unterteilt. Auf der photoaktiven Halbleiterschicht 4 ist eine Rückelektrodenschicht 5 angeordnet, die auch die Strukturierungslinien PA auffüllt. Die Rückelektrodenschicht 3 und die photoaktive Halbleiterschicht 4 sind durch Strukturierungslinien PR in einzelne Dünnschichtsolarzellen 1.1, 1.2 unterteilt. Die Serienverschaltung der einzelnen Dünnschichtsolarzellen 1.1, 1.2 erfolgt über Strukturierungslinien PA, die die Rückelektrodenschicht 3 eines ersten Bereichs 6.1 mit der Frontelektrodenschicht 5 eines zweiten Bereichs 6.1 elektrisch leitend verbinden. Die Materialien und Materialparameter der Substrate 2, 9 und des Schichtaufbaus 10 entsprechen dem Ausführungsbeispiel eines erfindungsgemäßen Dünnschichtsolarmoduls 1 in Substratkonfiguration in Figur 1. Die Absorberschicht 4.1 enthält beispielsweise einen pleitenden Absorber wie Cadmium-Tellurid (CdTe).

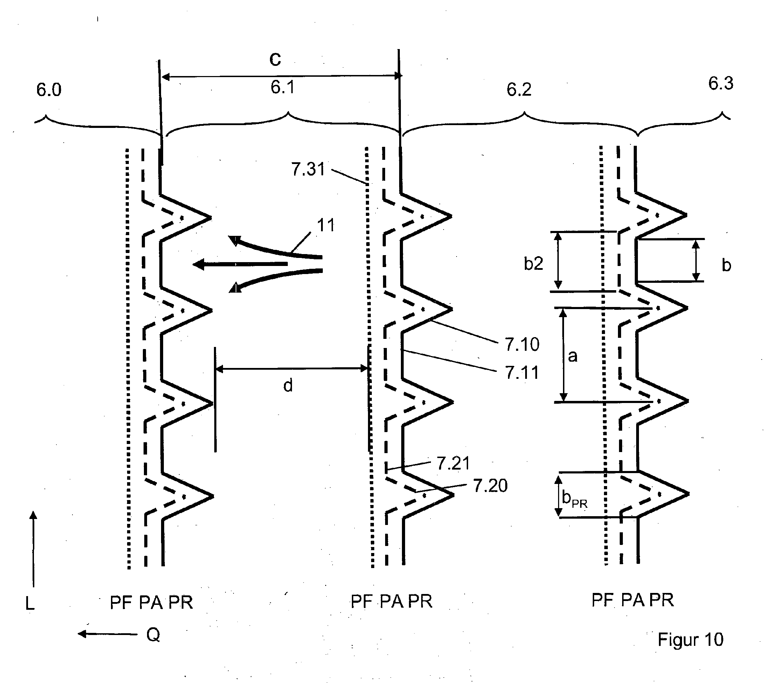

Figur 10 zeigt eine schematische Darstellung der Abfolge der Strukturierungslinien PR, PA und PF eines erfindungsgemäßen Dünnschichtsolarmoduls in Superstratekonfiguration, wie es beispielhaft in Figur 9 dargestellt ist.

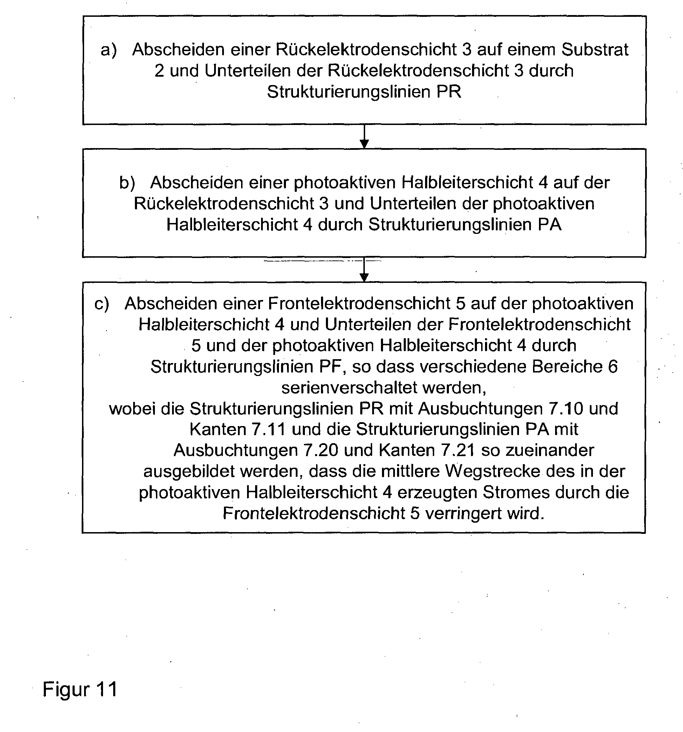

Figur 11 zeigt ein detailliertes Flussdiagramm des erfindungsgemäßen Verfahrens zur Herstellung und Serienverschaltung eines erfindungsgemäßen Dünnschichtsolarmoduls 1 in Substratkonfiguration. In einem ersten Schritt a) wird eine Rückelektrodenschicht 3 auf einem Substrat 2 abgeschieden und die Rückelektrodenschicht 3 durch Strukturierungslinien PR unterteilt. In einem zweiten Schritt b) wird eine photoaktive Halbleiterschicht 4 auf der Rückelektrodenschicht 3 abgeschieden und die photoaktive Halbleiterschicht 4 durch Strukturierungslinien PA unterteilt. In einem dritten Schritt c) wird eine Frontelektrodenschicht 5 auf der photoaktiven Halbleiterschicht 4 abgeschieden, die Frontelektrodenschicht 5 und die photoaktive Halbleiterschicht 4 durch Strukturierungslinien PF in Bereiche 6 unterteilt und die Frontelektrodenschicht 5 eines ersten Bereichs 6 in Serienverschaltung mit der Rückelektrodenschicht 3 eines zweiten Bereichs 6 verbunden. Dabei werden die Strukturierungslinien PR mit Ausbuchtungen 7.10 und Kanten 7.11 und die Strukturierungslinien PA mit Ausbuchtungen 7.20 und Kanten 7.21 so zueinander ausgebildet, dass die mittlere Wegstrecke des in der photoaktiven Halbleiterschicht 4 erzeugten Stromes durch die Frontelektrodenschicht 5 verringert wird.

Die Einschnitte für die Strukturierungslinien PR, PA und PF werden unter Einsatz einer geeigneten Strukturierungstechnologie, wie Laserschreiben, beispielsweise mit einem Nd:YAG-Laser, oder mechanischer Bearbeitung, beispielsweise durch Abheben oder Ritzen, ausgebildet.

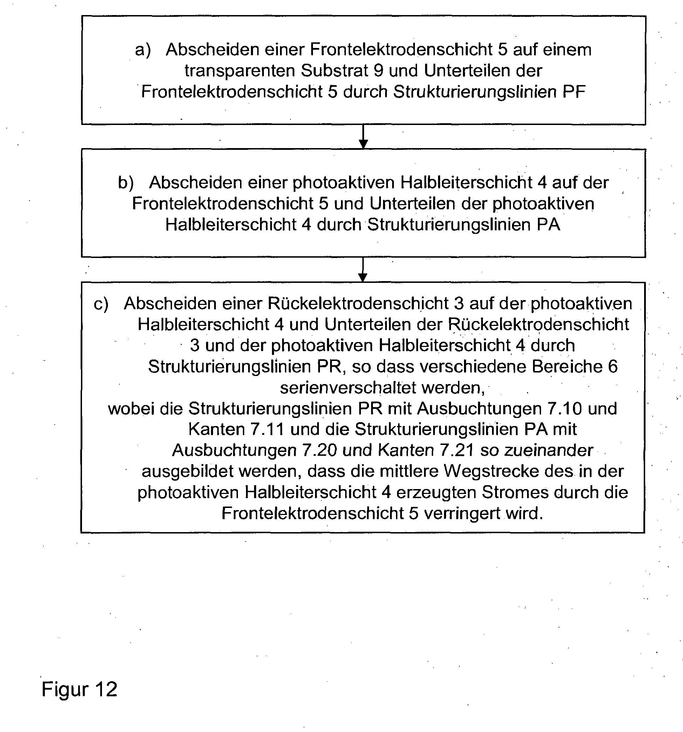

Figur 12 zeigt ein detailliertes Flussdiagramm einer alternativen Ausführungsform des erfindungsgemäßen Verfahrens zur Herstellung und Serienverschaltung eines erfindungsgemäßen Dünnschichtsolarmoduls 1 in Superstratekonfiguration. In einem ersten Schritt a) wird eine Frontelektrodenschicht 5 auf einem transparenten Substrat 9 abgeschieden und die Frontelektrodenschicht 5 durch Strukturierungslinien PF unterteilt. In einem zweiten Schritt b) wird eine photoaktive Halbleiterschicht 4 auf der Frontelektrodenschicht 5 abgeschieden und die photoaktive Halbleiterschicht 4 wird durch Strukturierungslinien PA unterteilt. In einem dritten Schritt c) wird eine Rückelektrodenschicht 3 auf der photoaktiven Halbleiterschicht 4 abgeschieden, die Rückelektrodenschicht 3 und die photoaktive Halbleiterschicht 4 durch Strukturierungslinien PR in Bereiche 6 unterteilt und die Rückelektrodenschicht 3 eines ersten Bereichs 6 in Serienverschaltung mit der Frontelektrodenschicht 5 eines zweiten Bereichs 6 verbunden. Dabei werden die Strukturierungslinien PR mit Ausbuchtungen 7.10 und Kanten 7.11 und die Strukturierungslinien PA mit Ausbuchtungen 7.20 und Kanten 7.21 so zueinander ausgebildet werden, dass die mittlere Wegstrecke des in der photoaktiven Halbleiterschicht 4 erzeugten Stromes durch die Frontelektrodenschicht 5 verringert wird.

### Bezugszeichenliste

- 1: Dünnschichtsolarmodul
- 1.1, 1.2, 1.3: Dünnschichtsolarzelle
- 2: Substrat
- 3: Rückelektrodenschicht
- 4: photoaktive Halbleiterschicht
- 4.1: Absorberschicht
- 4.2: Pufferschicht
- 5: Frontelektrodenschicht
- 6, 6.0, 6.1, 6.2, 6.3: Bereich
- 7.10, 7.20, 7.30: Ausbuchtung
- 7.11, 7.21, 7.31: Kante
- 8: Klebeschicht
- 9: transparentes Substrat
- 10: Schichtenaufbau
- 11: Stromfluss, Strompfad
- a: Abstand der Ausbuchtungen 7.10, 7.20, 7.30
- b1: Länge der Kante 7.11
- b2: Länge der Kante 7.21
- b3: Länge der Kante 7.31
- BF: Bereich der Frontelektrodenschicht 5
- b_{PR}: Basisbreite der Ausbuchtungen 7.10
- BR: Bereich der Rückelektrodenschicht 3
- c: Breite einer Dünnschichtsolarzelle 1.1, 1.2, 1.3
- d: Abstand
- wₒₚₜ: optimale Zellenbreite
- PR: Strukturierungslinie PR
- PA: Strukturierungslinie PA
- PF: Strukturierungslinie PF
- II: lichtaustrittsseitige Oberfläche des transparenten Substrats 9
- III: lichteintrittseitige Oberfläche des Substrats 2
- Q: Querrichtung
- L: Längsrichtung, Richtung der Serienverschaltung
- A-A': Schnittlinie

## Patentansprüche

1. Dünnschichtsolarmodul (1) mit Serienverschaltung, mindestens umfassend:
• eine Rückelektrodenschicht (3), die durch Strukturierungslinien PR in Bereiche BR unterteilt ist,
• eine photoaktive Halbleiterschicht (4), die auf der Rückelektrodenschicht (3) angeordnet ist und durch Strukturierungslinien PA unterteilt ist und
• eine Frontelektrodenschicht (5), die auf der, der Rückelektrodenschicht (3) gegenüberliegenden Seite der photoaktiven Halbleiterschicht (4) angeordnet ist und durch Strukturierungslinien PF in Bereiche BF unterteilt ist,
wobei Bereiche BF der Frontelektrodenschicht (5) mit benachbarten Bereichen BR der Rückelektrodenschicht (3) über Strukturierungslinien PA in Serienverschaltung elektrisch verbunden sind; **dadurch gekennzeichnet, dass** die Strukturierungslinien PR mit Ausbuchtungen (7.10) und Kanten (7.11) und die Strukturierungslinien PA mit Ausbuchtungen (7.20) und Kanten (7.21) so zueinander ausgebildet sind, dass durch eine reduzierte mittlere Wegstrecke des in der photoaktiven Halbleiterschicht (4) erzeugten Stromes durch die Frontelektrodenschicht (5) ein ohmscher Verlust verringert ist.

2. Dünnschichtsolarmodul (1) nach Anspruch 1, wobei die Strukturierungslinien PF mit Ausbuchtungen (7.30) und Kanten (7.31) ausgebildet sind.

3. Dünnschichtsolarmodul (1) nach einem der Ansprüche 1 oder 2, wobei die Ausbuchtungen (7.10, 7.20, 7.30) der Strukturierungslinie PR, der Strukturierungslinie PR und PA oder der Strukturierungslinie PR, PA und PF spitz zulaufend ausgebildet sind.

4. Dünnschichtsolarmodul (1) nach einem der Ansprüche 1 bis 3, wobei die Ausbuchtungen (7.10, 7.20 oder 7.30) von mindestens einer der Strukturierungslinien PR, PA oder PF dreiecksförmig ausgebildet sind.

5. Dünnschichtsolarmodul (1) nach einem der Ansprüche 1 bis 4, wobei die Ausbuchtungen (7.20) der Strukturierungslinie PA linienförmig oder rechteckig ausgebildet sind.

6. Dünnschichtsolarmodul (1) nach einem der Ansprüche 1 bis 5, wobei die Ausbuchtungen (7.10, 7.20, 7.30) benachbarter Strukturierungslinien PR, PA und PF zumindest annähernd parallel nebeneinander ausgebildet sind.

7. Dünnschichtsolarmodul (1) nach einem der Ansprüche 1 bis 6, wobei die Rückelektrodenschicht (3) einen niedrigeren elektrischen Flächenwiderstand, bevorzugt einen um einen Faktor 10 niedrigeren elektrischen Flächenwiderstand und besonders bevorzugt einen um einen Faktor 100 niedrigeren elektrischen Flächenwiderstand als die Frontelektrodenschicht (5) aufweist.

8. Dünnschichtsolarmodul (1) nach einem der Ansprüche 1 bis 7, wobei der minimale Abstand d der Ausbuchtungen (7.10) der Strukturierungslinie PR zur Strukturierungslinie PF eines benachbarten Bereiches kleiner oder gleich der optimalen Zellenbreite wₒₚₜ von 5 mm bis 15 mm beträgt.

9. Dünnschichtsolarmodul (1) nach Anspruch 8, wobei der Abstand a der Ausbuchtungen (7.10) der Strukturierungslinie PR kleiner oder gleich der optimalen Zellenbreite wₒₚₜ von 5mm bis 15mm beträgt.

10. Dünnschichtsolarmodul (1) nach einem der Ansprüche 1 bis 9, wobei die Rückelektrodenschicht (3) ein Metall, insbesondere Molybdän (Mo), Aluminium (Al), Kupfer (Cu), Titan (Ti) und/oder die Frontelektrodenschicht (5) eine transparente, leitfähige Metalloxidschicht, insbesondere Zinkoxid (ZnO), aluminiumdotiertes Zinkoxid (ZnO:Al), bordotiertes Zinkoxid (ZnO:B), indiumdotiertes Zinkoxid (ZnO:In), galliumdotiertes Zinkoxid (ZnO:Ga), fluordotiertes Zinnoxid (SnO₂:F), antimondotiertes Zinnoxid (SnO₂:Sb) oder Indiumzinnoxid (ITO) enthält.

11. Dünnschichtsolarmodul (1) nach einem der Ansprüche 1 bis 10, wobei die photoaktive Halbleiterschicht (4) amorphes, mikromorphes oder polykristallines Silizium, Cadmium-Tellurid (CdTe), organische Halbleiter, Gallium-Arsenid (GaAs), Chalkopyrit- oder Kesteritbasierte Halbleiter enthält.

12. Verfahren zur Herstellung und Serienverschaltung eines Dünnschichtsolarmoduls (1), wobei:
a) eine Rückelektrodenschicht (3) auf einem Substrat (2) abgeschieden wird und die Rückelektrodenschicht (3) durch Strukturierungslinien PR unterteilt wird,
b) eine photoaktive Halbleiterschicht (4) auf der Rückelektrodenschicht (3) abgeschieden wird und die photoaktive Halbleiterschicht (4) durch Strukturierungslinien PA unterteilt wird und
c) eine Frontelektrodenschicht (5) auf der photoaktiven Halbleiterschicht (4) abgeschieden wird, die Frontelektrodenschicht (5) und die photoaktive Halbleiterschicht (4) durch Strukturierungslinien PF in Bereiche (6) unterteilt werden und die Frontelektrodenschicht (5) eines ersten Bereichs (6) in Serienverschaltung mit der Rückelektrodenschicht (3) eines zweiten Bereichs (6) verbunden wird,
wobei die Strukturierungslinien PR mit Ausbuchtungen (7.10) und Kanten (7.11) und die Strukturierungslinien PA mit Ausbuchtungen (7.20) und Kanten (7.21) so zueinander ausgebildet werden, dass durch eine reduzierte mittlere Wegstrecke des in der photoaktiven Halbleiterschicht (4) erzeugten Stromes durch die Frontelektrodenschicht (5) ein ohmscher Verlust verringert wird.

13. Verfahren zur Herstellung und Serienverschaltung eines Dünnschichtsolarmoduls (1), wobei:
a) eine Frontelektrodenschicht (5) auf einem transparenten Substrat (9) abgeschieden wird und die Frontelektrodenschicht (5) durch Strukturierungslinien PF unterteilt wird,
b) eine photoaktive Halbleiterschicht (4) auf der Frontelektrodenschicht (5) abgeschieden wird und die photoaktive Halbleiterschicht (4) durch Strukturierungslinien PA unterteilt wird und
c) eine Rückelektrodenschicht (3) auf der photoaktiven Halbleiterschicht (4) abgeschieden wird, die Rückelektrodenschicht (3) und die photoaktive Halbleiterschicht (4) durch Strukturierungslinien PR in Bereiche (6) unterteilt werden und die Rückelektrodenschicht (3) eines ersten Bereichs (6) in Serienverschaltung mit der Frontelektrodenschicht (5) eines zweiten Bereichs (6) verbunden wird,
wobei die Strukturierungslinien PR mit Ausbuchtungen (7.10) und Kanten (7.11) und die Strukturierungslinien PA mit Ausbuchtungen (7.20) und Kanten (7.21) so zueinander ausgebildet werden, dass durch eine reduzierte mittlere Wegstrecke des in der photoaktiven Halbleiterschicht (4) erzeugten Stromes durch die Frontelektrodenschicht (5) ein ohmscher Verlust verringert wird.

14. Verwendung des Verfahrens nach Anspruch 12 oder 13 zur Herstellung und Serienverschaltung eines Dünnschichtsolarmoduls, insbesondere eines Dünnschichtsolarmoduls aus amorphen, mikromorphen oder polykristallinen Silizium, Cadmium-Tellurid (CdTe), Gallium-Arsenid (GaAs), Chalkopyrit- oder Kesterit-basierten Halbleiter oder organischen Halbleiter.

## Claims

1. Thin-film solar module (1) with series connection, comprising at least:
• a back electrode layer (3) that is divided into regions BR by structuring lines PR,
• a photoactive semiconductor layer (4) that is arranged on the back electrode layer (3) and is divided by structuring lines PA, and
• a front electrode layer (5) that is arranged on the side of the photoactive semiconductor layer (4) opposite the back electrode layer (3) and is divided into regions BF by structuring lines PF,
wherein regions BF of the front electrode layer (5) are electrically connected to adjacent regions BR of the back electrode layer (3) in series connection by means of structuring lines PA, **characterized in that** the structuring lines PR are formed with bulges (7.10) and edges (7.11), and the structuring lines PA are formed with bulges (7.20) and edges (7.21) relative to each other such that ohmic loss is reduced due to a reduced mean path distance of the current generated in the photoactive semiconductor layer (4) through the front electrode layer (5).

2. Thin-film solar module (1) according to claim 1,
wherein the structuring lines PF are formed with bulges (7.30) and edges (7.31).

3. Thin-film solar module (1) according to one of claims 1 or 2, wherein the bulges (7.10, 7.20, 7.30) of the structuring line PR, of the structuring line PR and PA, or of the structuring line PR, PA and PF are formed tapering to a point.

4. Thin-film solar module (1) according to one of claims 1 through 3, wherein the bulges (7.10, 7.20 or 7.30) of at least one of the structuring lines PR, PA or PF are formed triangular.

5. Thin-film solar module (1) according to one of claims 1 through 4, wherein the bulges (7.20) of the structuring line PA are formed linear or rectangular.

6. Thin-film solar module (1) according to one of claims 1 through 5, wherein the bulges (7.10, 7.20, 7.30) of adjacent structuring lines PR, PA, and PF are formed at least approx. parallel to each other.

7. Thin-film solar module (1) according to one of claims 1 through 6, wherein the back electrode layer (3) has a lower electrical sheet resistance, preferably an electrical sheet resistance lower by a factor of 10 and particularly preferably an electrical sheet resistance lower by a factor of 100 than the front electrode layer (5).

8. Thin-film solar module (1) according to one of claims 1 through 7, wherein the minimum distance d of the bulges (7.10) of the structuring line PR from the structuring line PF of an adjacent region is smaller than or equal to the optimal cell width wₒₚₜ of 5 mm to 15 mm.

9. Thin-film solar module (1) according to claim 8,
wherein the distance a between the bulges (7.10) of the structuring line PR is smaller than or equal to the optimal cell width wₒₚₜ of 5mm to 15mm.

10. Thin-film solar module (1) according to one of claims 1 through 9, wherein the back electrode layer (3) contains a metal, in particular molybdenum (Mo), aluminum (Al), copper (Cu), titanium (Ti), and/or the front electrode layer (5) contains a transparent, conductive metal oxide layer, in particular zinc oxide (ZnO), aluminum-doped zinc oxide (ZnO:Al), boron-doped zinc oxide (ZnO:B), indium-doped zinc oxide (ZnO:In), gallium-doped zinc oxide (ZnO:Ga), fluorine-doped tin oxide (SnO₂:F), antimony-doped tin oxide (SnO₂:Sb), or indium tin oxide (ITO).

11. Thin-film solar module (1) according to one of claims 1 through 10, wherein the photoactive semiconductor layer (4) contains amorphous, micromorphous, or polycrystalline silicon, cadmium telluride (CdTe), organic semiconductors, gallium arsenide (GaAs), chalcopyrite- or kesterite-based semiconductors.

12. Method for producing and series connecting a thin-film solar module (1), wherein:
a) a back electrode layer (3) is deposited on a substrate (2), and the back electrode layer (3) is divided by structuring lines PR,
b) a photoactive semiconductor layer (4) is deposited on the back electrode layer (3), and the photoactive semiconductor layer (4) is divided by structuring lines PA, and
c) a front electrode layer (5) is deposited on the photoactive semiconductor layer (4), the front electrode layer (5) and the photoactive semiconductor layer (4) are divided into regions (6) by structuring lines PF, and the front electrode layer (5) of a first region (6) is connected in series connection to the back electrode layer (3) of a second region (6),
wherein the structuring lines PR are formed with bulges (7.10) and edges (7.11), and the structuring lines PA are formed with bulges (7.20) and edges (7.21) relative to each other such that ohmic loss is reduced due to a reduced mean path distance of the current generated in the photoactive semiconductor layer (4) through the front electrode layer (5).

13. Method for producing and series connecting a thin-film solar module (1), wherein:
a) a front electrode layer (5) is deposited on a transparent substrate (9) and the front electrode layer (5) is divided by structuring lines PF,
b) a photoactive semiconductor layer (4) is deposited on the front electrode layer (5) and the photoactive semiconductor layer (4) is divided by structuring lines PA, and
c) a back electrode layer (3) is deposited on the photoactive semiconductor layer (4), the back electrode layer (3) and the photoactive semiconductor layer (4) are divided into regions (6) by structuring lines PR, and the back electrode layer (3) of a first region (6) is connected in series connection with the front electrode layer (5) of a second region (6),
wherein the structuring lines PR are formed with bulges (7.10) and edges (7.11) and the structuring lines PA are formed with bulges (7.20) and edges (7.21) relative to each other such that ohmic loss is reduced due to a reduced mean path distance of the current generated in the photoactive semiconductor layer (4) through the front electrode layer.

14. Use of the method according to claim 12 or 13 for producing and series connecting a thin-film solar module, in particular a thin-film solar module made of amorphous, micromorphous, or polycrystalline silicon, cadmium telluride (CdTe), gallium arsenide (GaAs), chalcopyrite- or kesterite-based semiconductors or organic semiconductors.

## Revendications

1. Module solaire à couches minces (1) avec raccordement en série, comprenant au moins:
• une couche d'électrodes arrière (3) qui, est subdivisée en zones BR par des lignes de structuration PR
• une couche semi-conductrice photoactive (4) qui est disposée sur la couche d'électrodes arrière (3) et subdivisée par des lignes de structuration PA et
• une couche d'électrodes avant (5), qui est disposée sur la surface de la couche d'électrodes arrière (3) en face de la couche semi-conductrice photoactive (4) et est subdivisée en zones BF par des lignes de structuration PF,
où des zones BF de la couche d'électrodes avant (5) sont connectées en série électriquement avec des régions voisines BR de la couche d'électrodes arrière (3) par des lignes de structuration PA, **caractérisé en ce que** les lignes de structuration PR avec renflements (7.10) et bords (7.11) et les lignes de structuration PA avec renflements (7.20) et bords (7,21) sont formées les unes par rapport aux autres de telle manière, qu'à travers un parcours moyen réduit du courant généré par la couche semi-conductrice photoactive (4) à travers la couche d'électrodes avant (5) une perte ohmique est diminuée.

2. Module solaire à couches minces (1) selon la revendication 1, dans lequel les lignes de structuration PF sont formées avec renflements (7.30) et les bords (7.31).

3. Module solaire à couches minces (1) selon l'une des revendications 1 ou 2, où les renflements (7.10, 7.20, 7.30) des lignes de structuration PR sont formées se rapprochant de manière affinée à la ligne de structuration PR et PA ou à la ligne de structuration PR, PA et PF.

4. Module solaire à couches minces (1) selon l'une des revendications 1 à 3, où les renflements (7.10, 7.20 ou 7,30) d'au moins l'une des lignes de structuration PR, PA et PF sont formés triangulaires.

5. Module solaire à couches minces (1) selon l'une des revendications 1 à 4, où les renflements (7.20) de la ligne de structuration PA sont formés linéaires ou rectangulaires.

6. Module solaire à couches minces (1) selon l'une des revendications 1 à 5, où les renflements (7.10, 7.20, 7.30) des lignes de structuration contigües PR, PA et PF sont formés au moins approximativement parallèles les unes aux autres.

7. Module solaire à couches minces (1) selon l'une des revendications 1 à 6, où la couche d'électrodes arrière (3) présente une résistivité superficielle électrique plus faible, de préférence une résistivité superficielle électrique plus faible par un facteur de 10 et tout particulièrement une résistivité superficielle électrique plus faible par un facteur de 100 que la couche d'électrodes avant (5)

8. Module solaire à couches minces (1) selon l'une des revendications 1 à 7, où la distance minimale d des renflements (7.10) des lignes de structuration PR à la ligne de structuration PF d'une zone voisine est inférieure ou égale à la largeur optimale de la cellule, wₒₚₜ de 5 mm à 15 mm

9. Module solaire à couches minces (1) selon la revendication 8, où la distance a des renflements (7.10) de la ligne de structuration PR est inférieure ou égale à la largeur de la cellule optimale wₒₚₜ de 5 mm à 15 mm

10. Module solaire à couches minces (1) selon l'une des revendications 1 à 9, où la couche d'électrodes arrière (3) contient un métal, en particulier du molybdène (MO), de l'aluminium (Al) du cuivre (CU), du titane (TI) et/ou la couche d'électrodes avant (5) contient une couche d'oxyde métallique transparent, conducteur, en particulier de l'oxyde de zinc (ZnO), de l'oxyde de zinc dopé en aluminium (ZnO:Al), de l'oxyde de zinc dopé en bore (ZnO:B), de l'oxyde de zinc dopé en indium (ZnO:In), de l'oxyde de zinc dopé en gallium (ZnO:GA), de l'oxyde d'étain dopé en fluor (ZnO2:F), de l'oxyde d'étain dopé en antimoine (Sn02:Sb) ou de l'oxyde d'indium-étain (ITO).

11. Module solaire à couches minces (1) selon l'une des revendications 1 à 10, où la couche semi-conductrice photoactive (4) contient du silicium amorphe, micromorphe, ou polycristallin, du tellurure de cadmium (CdTe), des semi-conducteurs organiques, de l'arséniure de gallium (GaAs), ou des semi-conducteurs basés sur du chalcopyrite ou du kësterite.

12. Procédé pour la fabrication et la connexion en série d'un module solaire à couches minces (1), où :
a) une couche d'électrodes arrière (3) est déposée sur un substrat (2) et la couche d'électrodes arrière (3) est subdivisée par des lignes de structuration PR
b) une couche semi-conductrice photoactive (4) est déposée sur la couche d'électrodes arrière (3) et la couche semi-conductrice photoactive (4) est subdivisée par des lignes de structuration PA et
c) une couche d'électrodes avant (5) est déposée sur la couche semi-conductrice photoactive (4), la couche d'électrodes avant (5) et la couche semi-conductrice photoactive (4) sont subdivisés en zones (6) par des lignes de structuration PE et la couche d'électrodes avant (5) d'une première zone (6) est connectée en série avec la couche d'électrodes arrière (3) d'une deuxième zone (6),
où les lignes de structuration PR avec des renflements (7.10) et bords (7.11) et les lignes de structuration PA avec renflements (7.20) et bords (7.21) sont formées les unes par rapport aux autres de telle manière, qu'à travers un parcours moyen réduit du courant généré par la couche semi-conductrice photoactive (4) à travers la couche d'électrodes avant (5) une perte ohmique est diminuée.

13. Procédé pour la fabrication et la connexion en série d'un module solaire à couches minces (1), où :
a) une couche d'électrodes avant (5) est déposée sur un substrat transparent (9) et la couche de l'électrode avant (5) est subdivisée par des lignes de structuration PF,
b) une couche semi-conductrice photoactive (4) est déposée sur la couche d'électrodes avant (5) et la couche semi-conductrice photoactive (4) est subdivisée par des lignes de structuration PA et,
c) une couche d'électrodes arrière (3) est déposée sur la couche semi-conductrice photoactive (4), la couche d'électrodes arrière (3) et la couche semi-conductrice photoactive (4) sont subdivisés en zones (6) par des lignes de structuration PR et la couche d'électrodes arrière (3) d'une première zone (6) est connectée en série avec la couche d'électrode avant (5) d'une deuxième zone (6)
où les lignes de structuration PR avec des renflements (7.10) et bords (7.11) et les lignes de structuration PA avec renflements (7.20) et bords (7.21) sont formées les unes par rapport aux autres de telle manière, qu'à travers un parcours moyen réduit du courant généré par la couche semi-conductrice photoactive (4) à travers la couche d'électrodes avant (5) une perte ohmique est diminuée.

14. L'utilisation du procédé selon la revendication 12 ou 13 pour la connexion série et de production de modules solaires minces, en particulier un module solaire de couche mince de silicium amorphe, micromorphe, ou polycristallin, de tellurure de cadmium (CdTe), de l'arséniure de gallium (CdTe), des semi-conducteurs basés sur le chalcopyrite ou le kësterite ou des semi-conducteurs organiques.
